# FASCICULE DE BREVET EUROPEEN

(11) **EP 0 443 483 B1**
(45) Date de publication et mention de la délivrance du brevet: **07.04.1993**
(21) Numéro de dépôt: 91102264.8
(22) Date de dépôt: 18.02.1991
(51) Int. Cl.: H05K 7/20, H05K 3/10, H05K 3/34

(54) **Procédé de brasage pour la fixation d'un élément tel qu'un substrat de circuit hybride à un support dissipateur thermique**
Lötverfahren für die Befestigung eines Elementes, wie z.B. eines hybriden Schaltkreissubstrats auf einer wärmeableitenden Unterlage
Soldering procedure for fixing an element as for example a substrate of a hybrid circuit on a heat dissipating base

(30) Priorité: 23.02.1990 FR 9002277
(43) Date de publication de la demande: 28.08.1991
(73) Titulaire: GEC ALSTHOM SA, 75116 Paris (FR)
(72) Inventeur: Chave, Jacques, F-69003 Lyon (FR)
(74) Mandataire: Weinmiller, Jürgen

(56) Documents cités:
- EP-A- 0 046 605
- EP-A- 0 139 431
- US-A- 4 603 374
- IBM TECHNICAL DISCLOSURE BULLETIN vol. 31, no. 9, février 1989, pages 1-3, New York, US; "Method of personalizing mesh patterns in ceramic green sheets using hybrid personalization techniques"

## Description

La présente invention concerne un procédé de brasage, applicable notamment à la fixation d'un substrat de circuit hybride à un support dissipateur thermique.

Dans un circuit hybride, notamment de puissance, il est nécessaire de prévoir une évacuation de la chaleur produite en cours de fonctionnement, afin d'éviter tout risque de détérioration de ce circuit.

Cette évacuation de chaleur est obtenue en fixant, généralement par brasage, le substrat du circuit hybride à un support dissipateur thermique, généralement en cuivre.

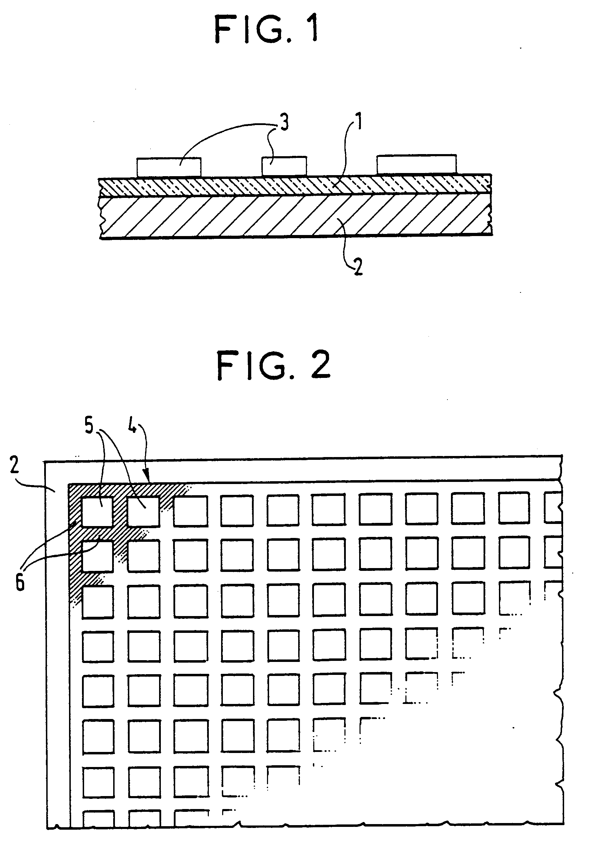

Un tel assemblage est représenté en coupe sur la figure 1, où le substrat du circuit hybride, le support dissipateur thermique et les composants portés par ce circuit sont repérés respectivement 1, 2, 3.

Pour effectuer ce brasage, on utilise généralement de la pâte à souder qui est étalée sur l'une des faces de l'un ou l'autre des éléments à braser, venant en regard de l'autre élément. La face du substrat du circuit hybride venant en regard du support dissipateur thermique est par ailleurs préalablement métallisée afin d'assurer la tenue du brasage. Dans les procédés connus antérieurement, cette métallisation est effectuée uniformément sur toute la surface de la face considérée.

Cette façon de procéder, quoiqu'utilisée depuis longtemps, présente un risque non négligeable de formation de poches d'air, à des emplacements aléatoires, entre ces deux éléments, au moment de leur assemblage, et, en cas de poches d'air suffisamment importantes, un risque élevé de détérioration des composants actifs du circuit hybride.

La présente invention a pour objet un procédé de fixation par brasage permettant d'éviter cet inconvénient.

La présente invention a pour objet un procédé de brasage, pour la fixation d'un élément tel qu'un substrat de circuit hybride à un support dissipateur thermique, procédé comportant une métallisation préalable effectuée sur ledit élément, essentiellement caractérisé en ce que ladite métallisation est effectuée suivant un motif discontinu, tel que les dimensions des aires non métallisées soient réduites à des dimensions ne présentant pas de risque de détérioration dudit élément en fonctionnement.

Les objets et caractéristiques de la présente invention apparaîtront plus clairement à la lecture de la description suivante d'un exemple de réalisation, faite en relation avec les dessins ci-annexés dans lesquels, outre la figure 1 déjà décrite,
- la figure 2 représente un motif possible de métallisation.

Dans l'exemple considéré, ce motif 4 est réalisé sur la face du substrat du circuit hybride venant en regard du support dissipateur thermique 2.

Ce motif consiste en l'occurence en un motif répétitif, plus particulièrement en une grille 4, dont les mailles sont suffisamment resserrées afin d'assurer correctement la fonction de transfert thermique entre le substrat du circuit hybride et le support dissipateur thermique.

A titre d'exemple les aires non métallisés de ce motif, telles que 5, peuvent avoir des dimensions de 1 à 9 mm², et les lignes métallisées telles que 6 peuvent avoir une largeur de l'ordre du mm.

Ce motif peut être obtenu par exemple par sérigraphie de Palladium-Argent, l'épaisseur de la couche ainsi obtenue étant de l'ordre d'une dizaine de microns.

Une couche uniforme de pâte à souder, d'une épaisseur de l'ordre d'une centaine de microns, est ensuite déposée soit sur le substrat du circuit hybride, par dessus le motif en grille, soit sur le support dissipateur thermique, qui est ici supposé métallique. Si ce support était isolant, il serait également préalablement métallisé, sans que la forme du motif de métallisation ne soit ici critique.

Au moment du brasage, seules les lignes métallisées du motif 4 assurent la tenue du brasage.

En d'autres termes, le motif 4 permet de localiser de façon prédéterminée la formation de poches d'air au moment du brasage, et de réduire ces poches d'air à des dimensions ne présentant aucun risque de détérioration du circuit hybride en fonctionnement.

La forme du motif 4 et ses dimensions peuvent varier en fonction des applications.

## Revendications

1. Procédé de brasage, pour la fixation d'un élément tel qu'un substrat de circuit hybride à un support dissipateur thermique, procédé comportant une métallisation préalable effectuée sur ledit élément, et nécessaire à la tenue du brasage, caractérisé en ce que ladite métallisation est effectuée suivant un motif discontinu (4), tel que les dimensions des aires non métallisées (5) soient réduites à des dimensions ne présentant pas de risque de détérioration dudit élément en fonctionnement.

2. Procédé selon la revendication 1, caractérisé en ce que ledit motif est répétitif.

3. Procédé selon la revendication 2, caractérisé en ce que ledit motif est une grille.

## Patentansprüche

1. Lötverfahren zur Befestigung eines Elements, z.B. eines Substrats eines Hybrid-Schaltkreises an einem wärmeableitenden Träger, wobei zuerst dieses Element metallisiert wird, um die Haftung der Lötschicht zu sichern, dadurch gekennzeichnet, daß die Metallisierung gemäß einem unterbrochenen Muster (4) durchgeführt wird, derart, daß die Größe der nicht metallisierten Bereiche (5) ausreichend gering ist, um die Gefahr einer Beschädigung des Elements im Betrieb auszuschließen.

2. Verfahren nach Anspruch 1, dadurch gekennzeichnet, daß das Muster repetitiv ist.

3. Verfahren nach Anspruch 2, dadurch gekennzeichnet, daß das Muster ein Gitter ist.

## Claims

1. Soldering procedure for fixing an element as for example a substrate of a hybrid circuit on a heat dissipating base, procedure comprising metal-plating carried out beforehand on said element, and necessary to withstand the soldering, characterised in that said metal-plating is effected in a discontinuous pattern (4) such that the dimensions of areas that are not metal-plated (5) are reduced to a size representing no risk of damage to said element in operation.

2. Procedure according to claim 1 characterised in that said pattern is repetitive.

3. Procedure according to claim 2 characterised in that said pattern is a grid.
